# EUROPEAN PATENT APPLICATION

(11) **EP 1 063 874 A1**
(43) Date of publication of application: **27.12.2000**
(21) Application number: 99304914.7
(22) Date of filing: 23.06.1999
(51) Int. Cl.: H05K 7/20, H04B 1/036

(54) **Heating control for base station**

(71) Applicant: LUCENT TECHNOLOGIES INC., Murray Hill, New Jersey 07974-0636 (US)
(72) Inventor: The designation of the inventor has not yet been filed
(74) Representative: Williams, David John

(57) **Abstract**

There is disclosed a method of controlling a heater in a housing. The method comprises: sensing a temperature of the environment outside the housing; comparing the outside temperature to a desired temperature within the housing; turning the heater on for a controlled length of time in responsive to the desired temperature being greater than the outside temperature; sensing a temperature of the environment inside the housing; comparing the inside temperature to the desired temperature; and responsive to the inside temperature being higher than the desired temperature, turning the heater off. Circuitry for performing the method is also disclosed.

## Description

### Field of the Invention

The present invention relates to a technique for controlling the temperature of an enclosure at a desired steady level, and particularly but not exclusively to the case where such an enclosure is the base station of a mobile communications system.

### Background to the Invention

Base stations for mobile communications systems may potentially experience a wide range of ambient temperatures. If the ambient temperature drops below a certain value the electronics in the base station may cease to function. At such low external ambient temperatures, the heating which arises from the electronics itself is insufficient to keep the internal temperature high enough for operation. Even at higher temperatures where the heat dissipation in the electronics is sufficient to keep the electronics operative, there can be a problem if a power cut occurs. If the internal temperature falls below that at which the electronics is operative, it will not restart when the power returns. A heater is therefore desired, and conventionally provided in such environments.

It is desirable for the temperature in the base station to be maintained at a constant level determined for optimum operation. However due to the need for the heater to be turned on and off responsive to fluctuations in external temperature (which heats the inside of the station), in reality significant fluctuations occur about the desired temperature level. It is an object of the present invention to provide an improved technique for controlling a heater in an environment such as a mobile communication system base station.

### Summary of the Invention

According to the present invention there is provided a method of controlling a heater in a housing, comprising: sensing a temperature of the environment outside the housing; comparing the outside temperature to a desired temperature within the housing; turning the heater on for a controlled length of time in responsive to the desired temperature being greater than the outside temperature; sensing a temperature of the environment inside the housing; comparing the inside temperature to the desired temperature; and responsive to the inside temperature being higher than the desired temperature, turning the heater off.

Responsive to the external temperature being less than the desired temperature, the heater is preferably turned on for a controlled length of time proportional to the difference between the external temperature and the reference temperature.

The heater is preferably turned on for a controlled length of time within a fixed period.

According to the invention there is also provided circuitry for controlling a heater in a housing, comprising a first temperature sensor for sensing a temperature of the environment outside the housing; a second temperature sensor for sensing a temperature of the environment in the housing, first comparison circuitry for comparing the outside temperature with a reference temperature; control means connected to the first comparison circuitry and for turning the heater on for a fixed time responsive to outside temperature being less than the reference temperature; second comparison circuitry for comparing the inside temperature with the reference temperature, wherein the control means is connected to the second comparison circuitry to turn the heater off responsive to the inside temperature being greater than the reference temperature.

Thus, by varying the on-state period to the off-state period of the heater in conjunction with the thermal inertia of the heater, the effect is to provide a housing such as a mobile communications base station with an intelligent and variable power control for its heater in dependence on the ambient temperature surrounding the housing.

The invention will now be described by way of example with reference to the accompanying drawings, in which:

### Brief Description of the Drawings

Figure 1 illustrates a base station of a mobile communication circuitry including temperature sensors for implementing the present invention;
Figure 2 illustrates a block diagram of circuitry for implementing the present invention; and
Figure 3 illustrates signals at various points in the block diagram of Figure 3.

### Description of Preferred Embodiment

The present invention will be described with particular reference to the base station of a mobile communications system, but it will be understood that the invention is more generally applicable to any type of housing or enclosure where it is desirable to control the heat generated by a heater in dependence on temperatures both inside and outside the housing.

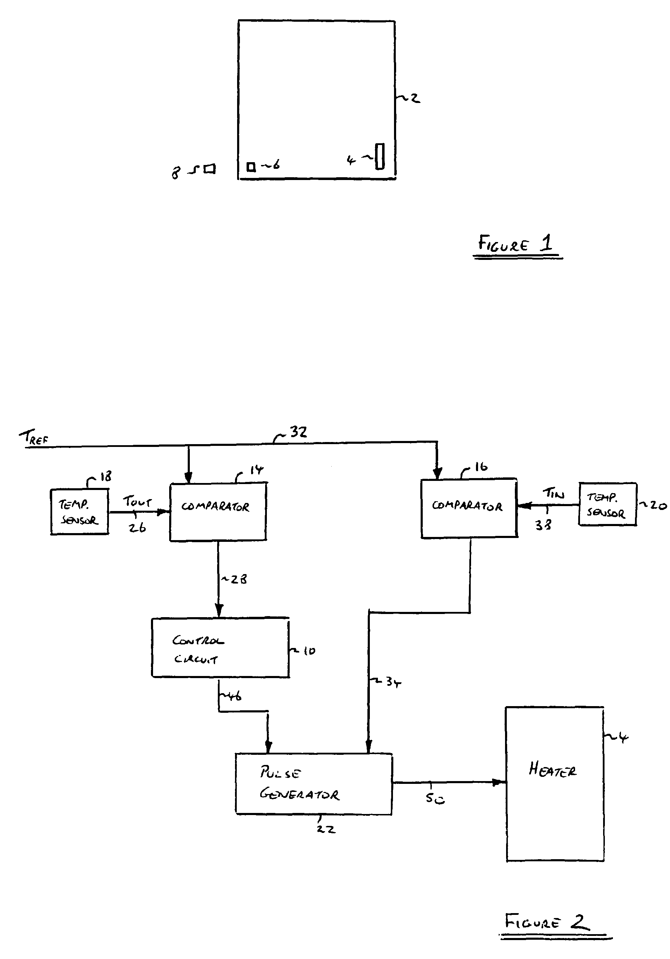

Referring to Figure 1, there is generally illustrated a base station of a mobile communication system, designated by reference numeral 2. The base station includes therein, in addition to electronic circuitry and other functional devices, a heater 4 and an environmental or internal temperature sensor 6 for sensing the current temperature inside the base station T_{IN}. Additionally shown, external to the base station 2, is an ambient or external temperature sensor 8 for sensing the current temperature outside the base station TOUT. The external temperature sensor may be positioned adjacent the outside wall of the base station, to give an indication of the temperature of the environment immediately outside the base station.

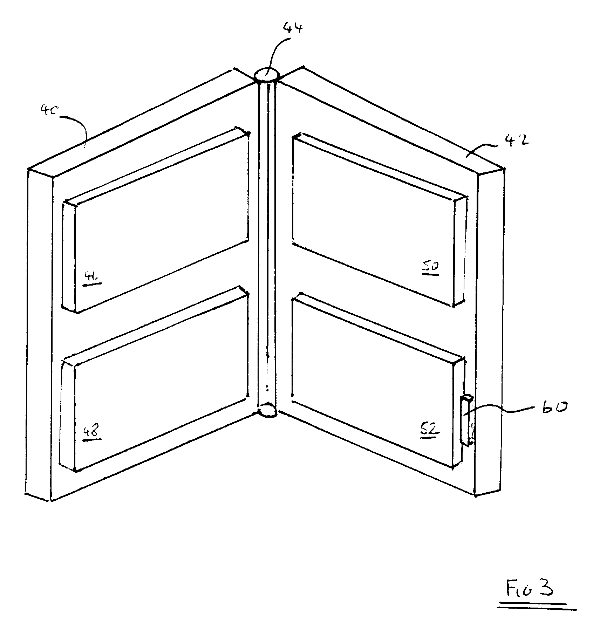

In Figure 2, there is illustrated a block diagram of control circuitry for controlling the heater 4 according to the present invention. In Figure 2 there is shown an external temperature sensing device 18 forming part of the external temperature sensor 8 of Figure 1, an internal temperature sensing device 20 forming part of the internal temperature sensor 6, an external temperature comparator 14, an internal temperature comparator 16. a control circuit 10, a pulse generator 22, and the heater 4.

The external temperature comparator 14 receives on a first input on line 26 the external temperature T_{OUT} sensed by the external temperature sensing device 18 and compares it to a reference temperature T_{REF} on line 32, which it receives on a second input. The internal temperature comparator 16 receives on line 38 the internal temperature T_{IN} sensed by the internal temperature sensing device 20 and compares it to the reference temperature T_{REF} on line 32, which it receives on a second input. The external temperature comparator 14 and the internal temperature comparator 16 each generate a signal on a respective one of lines 28 and 34 representing the result of the comparison operation performed, as will be described further hereinbelow. The output signal on line 28 forms an input to the control circuit 10, which in turn generates an output on line 46 to a pulse generator 22. The pulse generator additionally receives on a further input the output signal on line 34, and in turn generates an output on line 50 to the heater 4.

Due to the closed environment of the base station 2, and the heating effect caused by the electronic circuitry in the base station, the internal temperature of the base station T_{IN} will always be higher than the external temperature T_{OUT}. Thus the relationship T_{IN}>T_{OUT} always exists.

The reference temperature T_{REF} is the desired internal temperature of the base station, i.e. the temperature at which it is preferable to run the base station. As T_{OUT} is always less than T_{IN}, if T_{IN} is less than T_{REF} then T_{OUT} is also less than T_{REF}.

The output signal on line 28 is preferably a signal representing the magnitude of the difference between the external temperature and the reference temperature. When the external temperature is below the reference temperature, this difference gives an indication of the amount by which the temperature in the base station should be raised.

It is also not desirable for the temperature in the base station to unduly exceed the preferable operating temperature. Therefore the internal temperature comparator compares T_{IN} to T_{REF}, and if T_{IN} is greater than T_{REF} then the temperature within the base station is greater than that desired. The output signal on line 34 is preferably a pulse. In a first state the pulse indicates that the internal temperature is above the reference temperature, and therefore the base station does not need to be further heated. In the second state the pulse indicates that the internal temperature is below the reference temperature.

The control circuit 10 operates in dependence on the signal on line 28 to generate a pulse on line 46. The pulse on line 46 has two states. In a first state the pulse indicates that the heater should be switched on, and in a second state that the heater should be switched off. As will be further discussed hereinbelow, the length of the first state of the pulse is preferably proportional to the current difference between the external temperature and the reference temperature. Thus the heater is switched on for a length of time proportional to the amount by which the external temperature differs from the desired reference temperature.

The pulse generator then generates a pulse on line 50, corresponding to the pulse on line 46, to drive the heater 4. The pulse on line 50 has a first, active state in which the heater is turned on responsive thereto, and a second inactive state in which the heater is turned off responsive thereto. The heater is controlled by the control circuit 10 and the pulse generator 22 such that it is switched on when the pulse on line 28 is the one state, and the pulse on line 34 is not in the first state. The pulse generator is additionally controlled, as will be further described hereinbelow, by the pulse on line 34 such that the pulse on line 50 is inactive whenever the pulse on line 34 is in the first state, regardless of the state of the pulse on line 46.

This principle will be further described with reference to Figure 3. In Figure 3(a) there is shown a plot against time of the external and internal temperatures. At time to the internal and external temperatures both have values well below the reference temperature, the internal temperature being higher then the external temperature.

The comparator 14 generates a signal on line 28, which is illustrated in Figure 3(b), indicating that the external temperature is below the reference temperature, and the magnitude of the difference between the two.

Responsive to the signal on line 28, the control circuit 10 generates a pulse signal on line 46 as shown in Figure 3(c). The pulse signal has a period of tₚ. Because of the initial large difference between the outside temperature and the reference temperature, the pulse has a long active state (or high state) and a relatively short inactive state. Within the first pulse period tₚ the high signal of Figure 3(c) represents the active state, and the low signal the inactive state.

At this stage the signal on line 34 is zero, because the reference temperature is less than the internal temperature. Thus the signal on line 50 is a replica of the signal on line 46, and drives the heater 4.

At time t1, the internal temperature reaches the reference temperature, and hence the pulse on line 34 becomes active, as shown in Figure 3(d).

Responsive thereto, the output on line 50 becomes inactive (irrespective of the signal on line 46) and the heater is switched off.

At time t2 the internal temperature falls below the reference temperature, and as shown in Figure 3(d) the pulse 34 becomes inactive. Hence, once again, the signal on line 50 follows the signal on line 46. This pattern is followed, as shown in Figure 3(d), every time the internal temperature crosses the threshold set by the reference temperature.

Up until time t3, the external temperature remains approximately constant. Thus all the pulses generated in the time periods tₚ on signal line 46 in this time period have the same active period length. Thus the first six time periods, and the seventh time period which starts immediately before t₃, have the same active period length because the difference between the outside temperature and the reference temperature is constant in this period.

After time t₃ the outside temperature begins to steadily rise, until it reaches a further steady value at time t₄. Thus as shown in Figure 3(b) between times t₃ and t₄ the magnitude of the signal steadily decreases.

During this period, as illustrated in Figure 3(c), the active portion of the pulses on signal line 46 steadily decrease in each successive time period tₚ. Thus in the eight to eleventh time periods the active portion of the pulse becomes successively shorter. Thus the amount of time for which the signal 46 determines that the heater is to be switched on steadily decreases to correspond to the rise in the external temperature.

After time t₄, the external temperature plateaus out, and the active period of the twelfth pulse and onwards remains constant.

At all times, if the internal temperature exceeds the reference temperature as indicated by the pulse on line 34, then the output of the pulse generator 50 becomes inactive. As a result the pulse on line 50 which drives the heater has, for the temperature parameters shown in Figure 3(a), the format shown in Figure 3(e).

As a result the invention provides a technique for controlling the temperature in an enclosure such as the base station of a mobile communications system in which the desired environmental temperature is reached very rapidly, and thereafter the environment is maintained close to the desired temperature without severe fluctuations.

The pulse on line 50, as shown in Figure 5(e) controls the application in the heater of the a.c signal to the heater generating circuitry. Thus, whenever the signal on line 50 is inactive (low) the a.c. signals to the heater is turned off. In accordance with known techniques, in order to avoid EMC problems the a.c. signals may be turned on instantaneously on every zero voltage switching.

The invention is particularly concerned with ensuring control of the heating operation of the enclosure, and not a cooling operation. The internal temperature sensor prevents overshoot of the internal temperature.

## Claims

1. A method of controlling a heater in a housing, comprising: sensing a temperature of the environment outside the housing; comparing the outside temperature to a desired temperature within the housing; turning the heater on for a controlled length of time in responsive to the desired temperature being greater than the outside temperature; sensing a temperature of the environment inside the housing; comparing the inside temperature to the desired temperature; and responsive to the inside temperature being higher than the desired temperature, turning the heater off.

2. The method of claim 1 wherein responsive to the external temperature being less than the desired temperature, the heater is turned on for a controlled length of time proportional to the difference between the external temperature and the reference temperature.

3. The method of claim 1 or claim 2 wherein the heater is turned on for a controlled length of time within a fixed period.

4. Circuitry for controlling a heater in a housing, comprising a first temperature sensor for sensing a temperature of the environment outside the housing; a second temperature sensor for sensing a temperature of the environment in the housing, first comparison circuitry for comparing the outside temperature with a reference temperature; control means connected to the first comparison circuitry and for turning the heater on for a fixed time responsive to outside temperature being less than the reference temperature; second comparison circuitry for comparing the inside temperature with the reference temperature, wherein the control means is connected to the second comparison circuitry to turn the heater off responsive to the inside temperature being greater than the reference temperature.
